(19) Europäisches Patentamt
European Patent Office
Office européen des brevets

(11) **EP 2 099 127 B1**

(12) **EUROPÄISCHE PATENTSCHRIFT**

(45) Veröffentlichungstag und Bekanntmachung des Hinweises auf die Patenterteilung:
**13.08.2014 Patentblatt 2014/33**

(51) Int Cl.:
***H03F 3/217*** *(2006.01)*     ***H03K 3/78*** *(2006.01)*

(21) Anmeldenummer: **09405018.4**

(22) Anmeldetag: **28.01.2009**

(54) **Hochspannungsmodulator mit Transformator**

High voltage modulator with transformer

Modulateur de haute tension doté d'un transformateur

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **05.03.2008 CH 3282008**

(43) Veröffentlichungstag der Anmeldung:
**09.09.2009 Patentblatt 2009/37**

(73) Patentinhaber: **Ampegon AG**
**5300 Turgi (CH)**

(72) Erfinder: **Alex, Jürgen**
**79777 Untermettingen (DE)**

(74) Vertreter: **DREISS Patentanwälte PartG mbB**
**Patentanwälte**
**Postfach 10 37 62**
**70032 Stuttgart (DE)**

(56) Entgegenhaltungen:
**WO-A-95/10881**     **US-A1- 2002 186 577**
**US-A1- 2005 275 404**

• **ALEX J; BADER M; TROXLER J: "A new klystron modulator for XFEL based on PSM technology" 2007 IEEE PARTICLE ACCELERATOR CONFERENCE, 29. Juni 2007 (2007-06-29), Seiten 2200-2202, XP002483898 ISBN: 978-1-4244-0916-7**

**Beschreibung**

**Technisches Gebiet**

Die vorliegende Erfindung betrifft eine gepulste Hochspannungsversorgung, welche einen Hochspannungsmodulator in Form eines so genannten Pulse-Step-Modulators sowie einen Transformator umfasst.

**Stand der Technik**

Gepulste Hochspannungsversorgungen werden für eine Reihe von Anwendungen eingesetzt, z.B. in Teilchenbeschleunigern für die Hochenergiephysik, in Radarsystemen oder in Systemen zur Strahlenerzeugung für medizinische Anwendungen, in der Trinkwasseraufbereitung oder bei der Halbleiterherstellung.

Aus J. Alex et al., "A New Klystron Modulator for XFEL Based on PSM Technology", Proceedings of PAC07, Albuquerque, New Mexico, USA (2007), pp. 2200-2202 ist eine Hochspannungsversorgung bekannt, welche auf einem Hochspannungsmodulator in Form eines Pulse-Step-Modulators (PSM) mit nachgeschaltetem Transformator basiert.

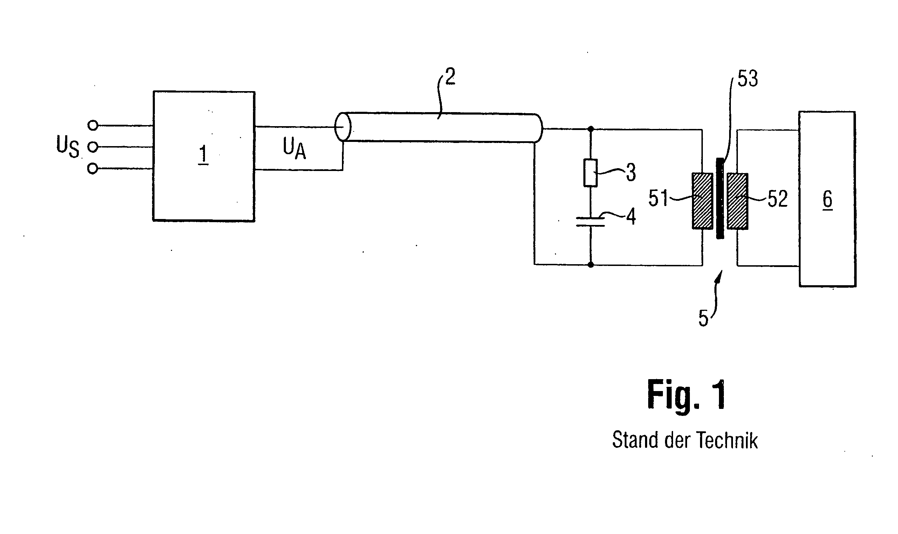

In der Fig. 1 ist ein schematisches Blockschaltbild einer derartigen Hochspannungsversorgung dargestellt. Der Hochspannungsmodulator 1 ist aus vierundzwanzig in Reihe geschalteten, identischen Schaltmodulen aufgebaut, wobei jedes der Module im aktiven Zustand eine vorbestimmte Gleichspannung an ihrem Ausgang erzeugt. Im passiven Zustand erlaubt jedes Modul einen unidirektionalen Stromfluss über eine Freilaufdiode, ohne dass eine nennenswerte Spannung zwischen den Ausgängen des Moduls anliegt. Derartige Anordnungen sind an sich als PSM-Schaltverstärker z.B. zur Ansteuerung der Senderöhre von AM-Rundfunksendern weit verbreitet.

Der Hochspannungsmodulator 1 wird von einer Versorgungsspannung $U_S$ versorgt und erzeugt eine gepulste Ausgangsspannung $U_A$. Diese wird durch eine Koaxialleitung 2 zu einem Pulstransformator 5 übertragen, dessen Primärwicklung 51 zusammen mit einem RC-Glied mit Widerstand 3 und Kapazität 4 den Lastkreis für den Hochspannungsmodulator 1 (Primärkreis) schliesst. Eine Sekundärwicklung 52 ist über einen Transformatorkern 53 induktiv mit der Primärwicklung 51 gekoppelt. Auf diese Weise werden die vom Hochspannungsmodulator 1 erzeugten Spannungspulse im Primärkreis zu Spannungspulsen höherer Spannung im Sekundärkreis hinauftransformiert und einer Last 6 in Form eines Klystrons zur Verfügung gestellt.

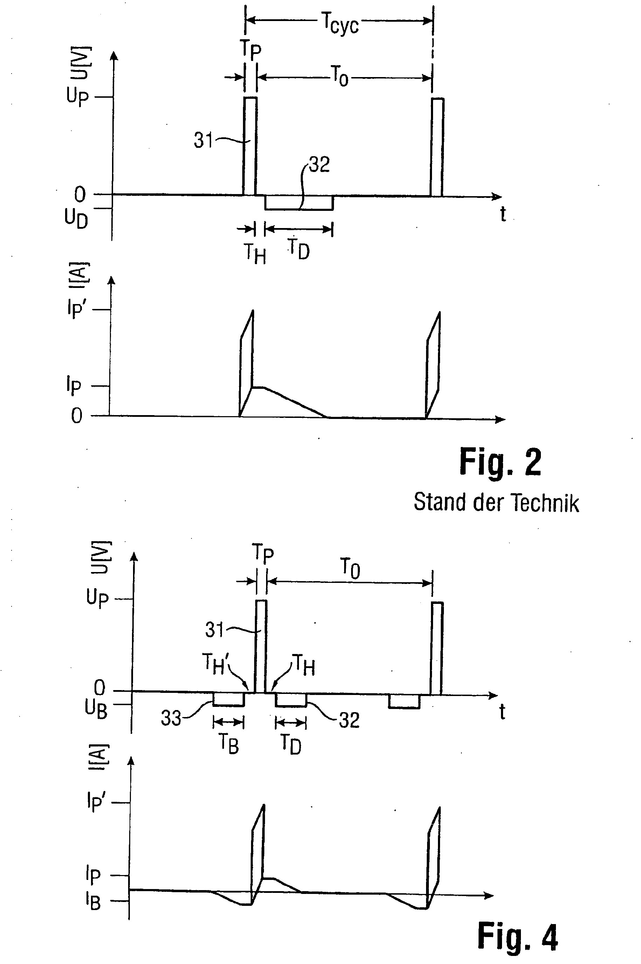

Ein möglicher Verlauf der Spannung U am Ausgang des Hochspannungsmodulators 1 und der dadurch resultierende Verlauf des Stromes I in der Primärwicklung 51 sind in stark vereinfachter und schematischer Form in der Fig. 2 illustriert. Der Hochspannungsmodulator gibt eine periodische Abfolge von positiven Spannungspulsen 31 mit einer Pulsspannung $U_P$, einer Pulsdauer $T_P$ und einer Periodendauer $T_{cyc}$ bzw. einem Pulsabstand $T_0$ ab. Diese Spannungs-pulse bewirken einen Magnetisierungsstrom in der Primärwicklung. Während jedes Pulses steigt dieser Magnetisierungsstrom von Null bis zu einem Wert $I_P$ an und erzeugt dabei ein Magnetfeld in der Primärwicklung und im Transformatorkern, dessen Feldstärke dem Magnetisierungsstrom proportional ist (untere Kurve im Stromdiagramm). Durch die dadurch bewirkte zeitlich veränderliche magnetische Flussdichte in der Sekundärwicklung entsteht eine Sekundärspannung, die zu einem Stromfluss durch die Last 6 führt. Dieser Laststrom im Sekundärkreis führt zu einem entsprechend zurücktransformierten Laststrom im Primärkreis, der dem Magnetisierungsstrom überlagert ist. In der Fig. 2 ist der Laststrom als zeitlich konstant angenommen. Der resultierende Gesamtstrom im Primärkreis, d.h. die Summe aus Magnetisierungsstrom und Laststrom, ist als obere Kurve im Stromdiagramm dargestellt. Der Gesamtstrom steigt ebenfalls zeitlich bis zu einem Wert $I_P$' an. Nach dem Ende des Pulses 31 betragen die Sekundärspannung und damit auch der Laststrom wieder Null. Der Magnetisierungsstrom fliesst im Primärkreis jedoch zunächst weiter und muss abgebaut werden, wobei der Kern wieder entmagnetisiert wird. Dies kann im Prinzip rein passiv geschehen, indem im Primärkreis gespeicherte magnetische Energie durch ein Widerstandsnetzwerk dissipiert wird. Eine solche rein passive Entmagnetisierung ist jedoch unter Umständen zu langsam, insbesondere, wenn das Tastverhältnis $T_P/T_{cyc}$ gross wird.

Um die Entmagnetisierung zu beschleunigen und gezielt zu steuern, wurde in dem Dokument von Alex et al. vorgeschlagen, eine aktive Entmagnetisierung vorzunehmen. Hierzu wird der Hochspannungsmodulator 1 so ausgestaltet, dass es dieser erlaubt, eine negative Spannung bei unidirektionalem Stromfluss an seinem Ausgang zu erzeugen (Zweiquadrantenbetrieb). Um eine negative Entmagnetisierungsspannung erzeugen zu können, wurden bei Alex et al. einigen der Schaltmodule sogenannte Inversmodule nachgeschaltet, die es erlauben, die vom jeweiligen zugeordneten Schaltmodul erzeugte Spannung selektiv zu invertieren.

Dadurch wird es möglich, nach dem Ende des positiven Spannungspulses 31 einen negativen Entmagnetisierungspuls 32 mit einer Entmagnetisierungsspannung $U_D$ und einer Entmagnetisierungs-Pulsdauer $T_D$ zu erzeugen. Aufgrund dieses Entmagnetisierungspulses sinkt der Strom im Primärkreis wieder ab, bis er den Wert Null erreicht. Wegen des Diodencharakters der Last im Sekundärkreis, die nur unidirektionalen Stromfluss erlaubt, fliesst während des Entmagnetisierungspulses kein Laststrom. Negative Werte des Stroms im Primärkreis sind bei dem Hochspannungsmodulator von Alex et al. bauartbedingt nicht möglich, so dass selbst bei einer längeren Dauer des Entmagnetisierungspulses der Strom im Primärkreis beim Wert Null verbleibt.

Die maximale Energie, die im Verlauf eines einzelnen Pulses über den Pulstransformator übertragbar ist, ist insbesondere durch die Sättigungsmagnetisierung des Transformatorkerns begrenzt. Um den zur Verfügung stehenden Magnetisierungsbereich des Kerns zwischen der negativen und der positiven Sättigungsgrenze möglichst gut auszunutzen, ist es grundsätzlich bekannt, den Kern eines Pulstransformators vor einem Spannungspuls entgegen der durch den Spannungspuls induzierten positiven Flussdichte negativ vorzumagnetisieren (negativer Bias).

Das Dokument von J. Biela et al., "Reset Circuits with Energy Recovery for Solid State Modulators", Proceedings of the Pulsed Power and Plasma Science Conference, Albuquerque (NM), USA, June 17 - 22, pp. 1309-1312 (2007) offenbart verschiedene Möglichkeiten, eine solche negative Vormagnetisierung zu erreichen. Insbesondere ist es aus diesem Dokument bekannt, am Transformator eine Hilfswicklung vorzusehen, die mit einer Gleichspannungsquelle verbunden ist und die dadurch den Transformatorkern negativ vormagnetisiert. Ausserdem sind in diesem Dokument verschiedene andere Anordnungen zur Erzeugung einer negativen Vormagnetisierung offenbart, die teilweise ohne eine Hilfswicklung am Transformator auskommen. Diese Anordnungen sind jedoch relativ kompliziert und können aufgrund ihrer Wirkungsweise nicht ohne Weiteres zusammen mit einem modularen Hochspannungsmodulator in PSM-Technologie eingesetzt werden.

Aus WO 95/10881 ist ein Schaltverstärker in Form eines Pulse-Step-Modulators bekannt, der geeignet ist, eine Ausgangsspannung mit beliebigem Vorzeichen und beliebiger Stromrichtung zur Verfügung zu stellen. Dieser Schaltverstärker dient zur Erzeugung von positiven wie negativen Lastspannungen in Anwendungen wie röhrenlosen Rundfunksendern, Hochleistungsfunktionsgeneratoren, Netzkupplungen, Sendern für drahtgebundene Kommunikation usw. Als besonderer Vorteil dieses Schaltverstärkers wird in dem genannten Dokument angeführt, dass ein Transformator am Ausgang entfallen kann. Ein Einsatz in Verbindung mit einem Transformator ist also in diesem Dokument gerade nicht vorgesehen.

## Darstellung der Erfindung

Es ist eine Aufgabe der vorliegenden Erfindung, eine gepulste Hochspannungsversorgung mit Transformator anzugeben, die den Magnetisierungsbereich des Transformatorkerns möglichst gut ausnutzt und einfach und betriebssicher aufgebaut ist.

Diese Aufgabe wird durch eine Hochspannungsversorgungsvorrichtung mit den Merkmalen des Anspruchs 1 gelöst.

Es ist eine weitere Aufgabe der vorliegenden Erfindung, ein Verfahren zur Erzeugung einer gepulsten Hochspannung anzugeben, bei dem ein Hochspannungsmodulator mit nachgeschaltetem Transformator eingesetzt wird und bei dem der Magnetisierungsbereich des Transformatorkerns möglichst gut ausgenutzt wird.

Diese Aufgabe wird durch ein Verfahren nach Anspruch 10 gelöst.

Vorteilhafte Ausgestaltungen sind in den abhängigen Ansprüchen angegeben.

Die vorliegende Erfindung stellt also gemäss einem ersten Aspekt eine gepulste Hochspannungsversorgungsvorrichtung zur Verfügung. Diese weist einen (vorzugsweise halbleitergesteuerten) Hochspannungsmodulator in Form eines Pulse-Step-Modulators mit einer Mehrzahl von Schaltstufen auf. Die Schaltstufen umfassen jeweils eine Spannungsquelle zur Erzeugung einer Gleichspannung sowie mindestens ein ansteuerbares Schaltelement, insbesondere ein Halbleiterschaltelement mit Steuerelektrode, z.B. einen IGBT, um die Gleichspannung selektiv (d.h. gezielt steuerbar) als Ausgangsspannung an den Ausgangsanschlüssen der Schaltstufe zur Verfügung zu stellen. Mindestens ein Teil der Schaltstufen sind dabei dazu ausgebildet, die Ausgangsspannung selektiv mit positivem oder negativem Vorzeichen zur Verfügung zu stellen (selektive Spannungsumkehr). Die Schaltstufen sind derart in Serie geschaltet, dass die Ausgangsspannungen der einzelnen Schaltstufen im Betrieb aufsummiert werden, und die so gebildete Summenspannung liegt unter Bildung eines Lastkreises an einer Last an. Die Vorrichtung umfasst des Weiteren einen Transformator mit mindestens einer Primärwicklung und mindestens einer Sekundärwicklung, die über einen Transformatorkern magnetisch mit der Primärwicklung gekoppelt ist. Dabei ist die Primärwicklung im Lastkreis des Hochspannungsmodulators angeordnet. Eine Steuereinrichtung für den Hochspannungsmodulator ist mit den Schaltelementen zusammenwirkend verbunden und steuert im Betrieb die Schaltelemente derart, dass der Hochspannungsmodulator an der Primärwicklung mindestens einen positiven Spannungspuls ("Übertragungspuls") zur Energieübertragung an die Last des Sekundärkreises erzeugt, welcher zu einem positiven Stromfluss in der Primärwicklung führt. Dabei ist der Hochspannungsmodulator derart ausgebildet, dass er einen Stromfluss durch den Lastkreis sowohl in einer positiven als auch in einer dazu entgegengesetzten negativen Richtung erlaubt. Insgesamt wird also eine Vierquadrantensteuerung möglich. Die Steuereinrichtung steuert im Betrieb die Schaltelemente derart, dass der Hochspannungsmodulator vor dem positiven Spannungspuls eine negative Vormagnetisierungsspannung abgibt, insbesondere in der Form mindestens eines Pulses, um den Transformatorkern durch einen negativen Stromfluss negativ vorzumagnetisieren.

Auf diese Weise wird es durch eine einfache Modifikation des Hochspannungsmodulators möglich, die magnetischen Eigenschaften des Transformatorkerns optimal auszunutzen, insbesondere den vollen Flussdichtenbereich zwischen der negativen und der positiven Sättigung auszunutzen, ohne dass hierzu eine eigenständige Vormagnetisierungsschaltung nötig wäre. Durch den Aufbau mit mehreren Schaltstufen in Serienanordnung kann zudem leicht eine Redundanz erreicht werden, indem mehr Schaltstufen vorgesehen werden, als zur Erzeugung des Spannungspulses und/oder des Vormagnetisierungspulses eigentlich nötig wären. Fällt eine Schaltstufe aus, so kann eine andere Schaltstufe deren Funktion übernehmen.

Der Hochspannungsmodulator ist modular aufgebaut, indem jede Schaltstufe ein erstes Schaltstufenmodul umfasst, welches dazu ausgebildet ist, eine unipolare Ausgangsspannung abzugeben. Mindestens ein Teil der Schaltstufen umfasst zudem ein zweites Schaltstufenmodul (Inversmodul), welches dazu ausgebildet ist, die Ausgangsspannung des zugeordneten ersten Schaltstufenmoduls selektiv zu invertieren. Die ersten Schaltstufenmodule und die zweiten Schaltstufenmodule weisen vorzugsweise ein identisches Schaltungslayout auf und unterscheiden sich lediglich in ihrer Bestückung, d.h. durch das Vorhandensein oder Weglassen bestimmter elektrischer Elemente. Dadurch kann ein mechanisch und elektrisch sehr einfacher Aufbau mit Modulen gleicher Abmessungen und gleicher elektrischer Anschlüsse erreicht werden. Bei einer Änderung der Anforderungen an die Ausgangsspannung kann die Zahl der benötigten Module leicht angepasst werden, ohne dass die Module selbst wesentlich verändert werden müssen.

Die Schaltstufen sind in Form von Halbbrückenschaltungen aufgebaut, wobei bei den Schaltstufen mit Spannungsumkehr die Halbbrücke zu einer vollen H-Brücke ergänzt ist. Jede Schaltstufe weist also eine erste Halbbrücke auf, welche mit der Spannungsquelle verbunden ist und welche ein erstes und ein zweites Schaltelement umfasst, wobei das erste und das zweite Schaltelement über einen gemeinsamen Knotenpunkt (Mittenkontakt) in Serie geschaltet sind. Der gemeinsame Knotenpunkt ist direkt oder indirekt (über passive Bauelemente wie Spulen, Widerstände usw.) mit einem ersten Ausgangsanschluss der Schaltstufe verbunden. Wenn kein Inversmodul folgt, kann der andere Ausgangsanschluss je nach Bedarf z.B. mit dem positiven oder dem negativen Potential der Spannungsquelle verbunden sein. Das erste und das zweite Schaltelement sind mit ihren Steuerelektroden derart mit der Steuereinrichtung verbunden, dass sie durch die Steuereinrichtung gezielt in einen leitenden oder einen nichtleitenden Zustand bringbar sind.

Die Schaltstufen mit Spannungsumkehr umfassen entsprechend eine zweite Halbbrücke, die parallel zur ersten Halbbrücke mit der Spannungsquelle verbunden ist und die ein drittes und ein viertes Schaltelement umfasst, wobei das dritte und das vierte Schaltelement über einen gemeinsamen zweiten Knotenpunkt (Mittenkontakt) in Serie geschaltet sind. Der zweite Knotenpunkt ist dann direkt oder indirekt mit einem zweiten Ausganganschluss der Schaltstufe verbunden. Auch das dritte und das vierte Schaltelement sind entsprechend derart mit der Steuereinrichtung verbunden, dass sie durch die Steuereinrichtung gezielt in einen leitenden oder einen nichtleitenden Zustand bringbar sind.

Parallel zu mindestens einem Teil der Schaltelemente können Freilaufdioden angeordnet sein, um die entsprechenden Schaltelemente vor unerwünschten Spannungen zu schützen und um einen Stromfluss selbst dann sicherzustellen, falls eines der Schaltelemente oder die Steuereinrichtung ausfallen sollte.

Die Steuereinrichtung kann zudem, wie dies aus dem Stand der Technik an sich schon bekannt ist, nach dem positiven Spannungspuls die Schaltelemente derart steuern, dass der Hochspannungsmodulator nach dem positiven Spannungspuls eine negative Entmagnetisierungsspannung abgibt, um den Transformatorkern zumindest teilweise zu entmagnetisieren.

Bevorzugt entspricht die Summe aus der negativen Flussdichtenänderung aufgrund der Vormagnetisierungsspannung und der Entmagnetisierungsspannung betragsmässig im Wesentlichen gerade der positiven Flussdichtenänderung aufgrund des Übertragungspulses. In anderen Worten erfolgt möglichst die gesamte Flussdichtenänderung gezielt durch Anlegen von Spannungen und nur in untergeordnetem Mass z.B. durch Dissipation in ohmschen Widerständen oder durch andere Verluste. Auf die Spannungen bezogen bedeutet dies, dass die Summe der zeitlichen Integrale der Vormagnetisierungsspannung und der Entmagnetisierungsspannung betragsmässig im Wesentlichen dem zeitlichen Integral des Spannungspulses entspricht.

Es ist zudem vorteilhaft, wenn die negative Flussdichte des Kerns nach der Vormagnetisierung betragsmässig im Wesentlichen der positiven Flussdichte am Ende des Spannungspulses entspricht, die Flussdichtenänderung also "symmetrisch" um den Wert Null herum erfolgt. In diesem Fall führt dies zur Forderung, dass das zeitliche Integral der Vormagnetisierungsspannung betragsmässig im Wesentlichen der Hälfte des zeitlichen Integrals des Spannungspulses entspricht.

Gemäss einem zweiten Aspekt bezieht sich die vorliegende Erfindung auf ein Verfahren zur Erzeugung einer gepulsten Hochspannung gemäss der Ansprüche 10 und 11.

Die Steuerung der Schaltelemente des Hochspannungsmodulators zur Erzeugung der Pulsfolge kann in Hardware und/oder Software implementiert sein. Vorzugsweise ist eine Software vorhanden (d.h. ein Computerprogrammprodukt mit Computerprogrammmitteln, um einen oder mehrere Prozessoren der Steuereinrichtung zu steuern), die ihrer Ausführung die Steuereinrichtung und damit die Schaltelemente derart steuert, dass die genannte Abfolge von Spannungen erzeugt wird.

**Kurze Beschreibung der Zeichnungen**

Bevorzugte Ausführungsformen der Erfindung werden im Folgenden anhand der Zeichnungen beschrieben, in denen zeigen:

Fig. 1     ein schematisches Blockschaltbild einer Hochspannungsversorgung des Standes der Technik;

Fig. 2     ein schematisches Diagramm, das den Verlauf von Strom und Spannung für die Hochspannungsversorgung gemäss dem Stand der Technik darstellt;

Fig. 3     schematisch eine Hysteresekurve eines weichmagnetischen Transformatorkerns;

Fig. 4     ein schematisches Diagramm, das den Verlauf von Strom und Spannung für eine erfindungsgemässe Hochspannungsversorgung darstellt;

Fig. 5     ein vereinfachtes schematisches Schaltbild eines Hochspannungsmodulators gemäss einem bevorzugten Ausführungsbeispiel der vorliegenden Erfindung;

Fig. 6     ein vereinfachtes Schaltbild eines Moduls einer Schaltstufe gemäss einem bevorzugten Ausführungsbeispiel der vorliegenden Erfindung; sowie

Fig. 7     ein vereinfachtes Schaltbild einer vollständigen Schaltstufe mit Inversmodul.

## Ausführliche Beschreibung bevorzugter Ausführungsformen

Die Prinzipien, die der vorliegenden Erfindung zu Grunde liegen, lassen sich am besten ausgehend von der Hochspannungsversorgung des Standes der Technik erläutern, wie sie in dem oben diskutierten Dokument von J. Alex et al. angegeben ist und wie sie oben in Zusammenhang mit den Figuren 1 und 2 erläutert wurde. Bei dieser bekannten Hochspannungsversorgung erlaubt der Hochspannungsmodulator 1, der die Primärwicklung des Pulstransformators ansteuert, einen Zweiquadrantenbetrieb (positive und negative Ausgangsspannung bei unidirektionaler Stromrichtung). Der Hochspannungsmodulator gibt eine Folge positiver Spannungspulse 31 ab, die einen positiven Stromfluss durch die Primärwicklung bewirken. Nach jedem Spannungspuls folgt ein negativer Entmagnetisierungspuls, bis der (positive) Strom in der Primärwicklung wieder bis zum Wert Null abgebaut ist. Negative Ströme sind bauartbedingt nicht möglich.

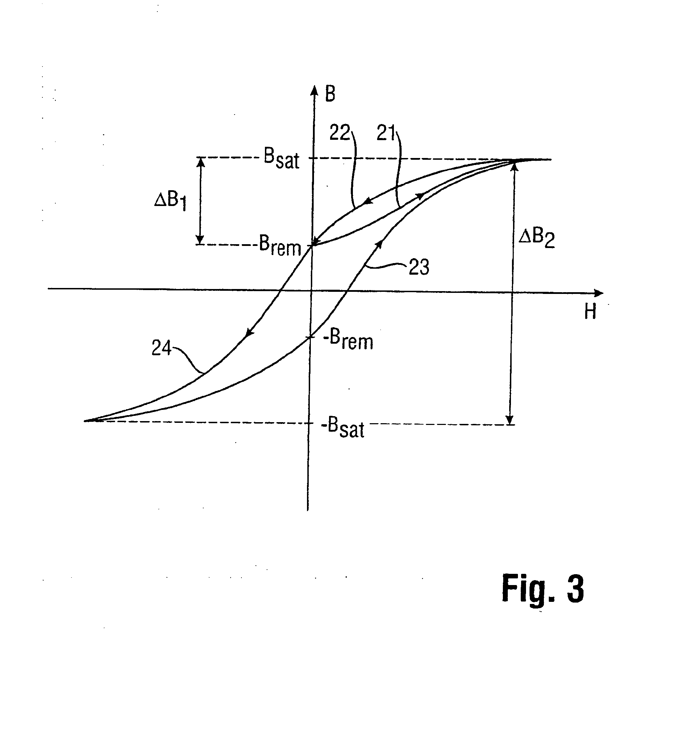

Die maximale Pulsenergie, die bei dieser Betriebsweise durch den Pulstransformator übertragbar ist, ist insbesondere durch die Sättigungsmagnetisierung des Transformatorkerns limitiert. Dies ist in der Fig. 3 illustriert, die schematisch eine typische Hysteresekurve, d.h. den Verlauf der magnetischen Flussdichte B in Abhängigkeit von der magnetischen Feldstärke H, eines weichmagnetischen Materials darstellt, wie es häufig in Transformatorkernen eingesetzt wird. Zu Beginn des Spannungspulses 31 entspricht die magnetische Flussdichte B im Kern der (positiven) Remanenzflussdichte $B_{rem}$. Im Verlauf des Spannungspulses 31 steigt die magnetische Flussdichte B entsprechend dem Zweig 21 der Hysteresekurve der Fig. 2 an. Die Steigung dB/dH nimmt mit steigender Feldstärke H ab, bis der Kern in die magnetische Sättigung gelangt und die Permeabilität des Kern nahezu auf den Wert 1 abgesunken ist. Im Verlauf des anschliessenden Entmagnetisierungspulses kehrt die Flussdichte B entlang dem Zweig 22 der Hysteresekurve wieder zum Wert $B_{rem}$ zurück. Zweckmässigerweise wird die Pulsdauer $T_P$ des Spannungspulses 31 kurz genug gewählt, dass die Sättigungsgrenze des Kerns nicht erreicht wird, da sich die Übertragungseigenschaften des Transformators jenseits der Sättigungsgrenze stark verschlechtern. Effektiv nutzbar für eine Energieübertragung im Transformator ist also lediglich die Amplitude $\Delta B_1$ der Flussdichte, die im Wesentlichen der Differenz zwischen der (positiven) Sättigungsgrenze $B_{sat}$ und der (positiven) Remanenz $B_{rem}$ entspricht.

Der nutzbare Flussdichtenbereich lässt sich aber stark erweitern, wenn der Transformatorkern vor dem Spannungspuls negativ vormagnetisiert wird. Die Vormagnetisierung kann z.B. bis nahezu zur negativen Sättigungsgrenze $-B_{sat}$ erfolgen. Während der Vormagnetisierung folgt die Flussdichte dem Zweig 24 der Hysteresekurve. Beim anschliessenden Spannungspuls steht nun der Flussdichtenbereich $\Delta B_2$ zur Energieübertragung im Transformator zur Verfügung, der sich von $-B_{sat}$ bis $+B_{sat}$ erstreckt. Dabei folgt die Flussdichte dem Zweig 23 der Hysteresekurve. Die magnetischen Eigenschaften des Kerns können auf diese Weise sehr viel effizienter genutzt werden. Effektiv kann auf diese Weise bei gleicher Übertragungsleistung ein Kern mit ungefähr lediglich halbem Volumen verwendet werden.

Falls bei der Anordnung von Alex et al. eine solche Vormagnetisierung erfolgen soll, so wäre es nötig, hierfür einen separaten Schaltkreis vorzusehen, der den Kern z.B. über eine Hilfswicklung magnetisiert. Die vorliegende Erfindung schlägt stattdessen vor, hierzu den Hochspannungsmodulator selbst zu verwenden. Hierzu wird der Hochspannungsmodulator dahingehend verändert, dass negative Ströme ermöglicht werden (Vierquadrantenbetrieb). Der Hochspannungsmodulator wird dann so betrieben, dass vor dem eigentlichen Spannungspuls 31 eine negative Vormagnetisierungsspannung erzeugt wird, die in der Primärwicklung einen negativen Vormagnetisierungsstrom bewirkt.

Ein möglicher entsprechender Spannungs- und Stromverlauf ist in der Fig. 4 illustriert. Vor dem positiven Spannungspuls 31 wird vom Schaltverstärker ein negativer Vormagnetisierungspuls 33 mit einer negativen Vormagnetisierungsspannung (Bias-Spannung) $U_B$ und einer Pulsdauer $T_B$ erzeugt. Dieser bewirkt einen negativen Magnetisierungsstrom im Primärkreis, dessen Betrag mit steigender Pulsdauer ansteigt. Am Ende des Vormagnetisierungspulses hat der Strom einen negativen Wert $I_B$ erreicht. In dieser Phase fliesst kein Laststrom. Dies kann durch den Charakter der Last bedingt sein, wenn die Last nur unidirektionalen Stromfluss zulässt, wie z.B. bei einer Klystronröhre. Bei anderen Arten von Last kann in dieser Phase die Last auch aktiv abgeschaltet sein. In der folgenden Wartezeit $T_H{}'$ bleibt dieser Strom weitgehend erhalten (unter Vernachlässigung ohmscher Verluste). Beim nachfolgenden positiven Spannungspuls 31 steigt nun der Magnetisierungsstrom, ausgehend vom negativen Wert $I_B$, in positiver Richtung an, bis er am Ende des Spannungspulses 31 einen positiven Wert $I_P$ erreicht hat. Im selben Masse steigt die magnetische Feldstärke im Transformatorkern von einem negativen Ausgangswert bis zu einem positiven Endwert hin an. Während dieses Anstiegs ist dem Magnetisierungsstrom nun ein (transformierter) Laststrom überlagert, wie dies im Zusammenhang mit der Fig. 2 beschrieben wurde. Nach dem Ende des Spannungspulses entfällt der Laststrom erneut, während der Magnetisierungsstrom während einer Wartezeit $T_H$ weitgehend erhalten bleibt (unter Vernachlässigung ohmscher Verluste) und dann, wie im Zusammenhang mit der Fig. 3 beschrieben, unter dem Einfluss eines Entmagnetisierungspulses 32 bis zum Wert Null absinkt, bevor ein neuer Pulszyklus beginnt.

Um die magnetischen Eigenschaften des Kerns möglichst gut auszunutzen, sind der Vormagnetisierungspuls und der Entmagnetisierungspuls bevorzugt so gewählt, dass die magnetische Feldstärke bzw. die Flussdichte im Kern zu Beginn des positiven Spannungspulses betragsmässig im Wesentlichen der Feldstärke bzw. der Flussdichte am Ende des positiven Spannungspulses entspricht, jedoch mit umgekehrtem Vorzeichen. In anderen Worten ändert sich vorzugsweise die Feldstärke bzw. Flussdichte während des positiven Spannungspulses von einem negativen Wert zu einem positiven Wert von im Wesentlichen gleichem Absolutbetrag. Da im vorliegenden Beispiel die magnetische Feldstärke allein durch den Magnetisierungsstrom in der Primärwicklung bestimmt ist, gilt also zweckmässigerweise $I_B \approx -I_P$ bzw. für die Spannungen U:

$$\int_{T_B} U dt \approx -\frac{1}{2}\int_{T_P} U dt \approx \int_{T_D} U dt . \qquad \text{(Gleichung 1)}$$

In Worten ausgedrückt, entspricht zweckmässigerweise das Integral der Spannung an der Primärwicklung während des Vormagnetisierungspulses (in der Fig. 4 die Fläche unter dem Vormagnetisierungspuls 33) betragsmässig im Wesentlichen der Hälfte des Integrals der Spannung während des positiven Spannungspulses (in der Fig. 4 also der Hälfte der Fläche unter dem Spannungspuls 32). Um anschliessend eine vollständige Entmagnetisierung zu erreichen, wird zweckmässigerweise das Integral der Spannung während des Entmagnetisierungspulses betragsmässig ebenfalls im Wesentlichen der Hälfte des Integrals des positiven Spannungspulses betragen. Bei diesen Überlegungen wurden ohmsche Verluste vernachlässigt. Bei Vorliegen von ohmschen Verlusten kann der Vormagnetisierungspuls entsprechend verlängert werden bzw. dessen Spannung erhöht werden, um diese Verluste auszugleichen, und der Entmagnetisierungspuls kann entsprechend verkürzt werden. Der Begriff "im Wesentlichen" bedeutet also im vorliegenden Fall "ungefähr und unter Vernachlässigung ohmscher Verluste".

In der Praxis ist es häufig nicht möglich, die Spannung des Vormagnetisierungspulses exakt vorzugeben. Das Ende des Vormagnetisierungspulses wird dann im Betrieb vorzugsweise durch eine Messung der Spannungs-Zeit-Fläche (d.h. des Integrals der Spannung über die Zeit) bestimmt. Der Vormagnetisierungspuls sollte in diesem Fall so früh beginnen, dass selbst bei der niedrigsten zu erwartenden Vormagnetisierungsspannung eine ausreichende negative Vormagnetisierung erreicht wird, bevor der positive Spannungspuls beginnt. In der Regel wird der gewünschte Wert der Vormagnetisierung früher erreicht. In diesem Fall wird die Primärwicklung während einer Haltezeit $T_H'$ im Wesentlichen spannungslos gehalten, bis der positive Spannungspuls beginnt. Nach dem Ende des positiven Spannungspulses kann eine weitere spannungslose Haltezeit $T_H$ vorgesehen sein, die jedoch sehr kurz gewählt sein kann und in der Praxis z.B. lediglich durch die Rechengeschwindigkeit der Steuerung begrenzt sein wird.

Diese Wartezeiten können gegebenenfalls aber auch entfallen. Ebenfalls ist es denkbar, die Pulse für die Entmagnetisierung und für die negative Vormagnetisierung zu einem einzigen Puls zusammenzuziehen. Selbstverständlich können die Entmagnetisierung und die Vormagnetisierung statt jeweils durch einen einzigen zusammenhängenden Puls aber auch durch eine Abfolge mehrerer diskreter Pulse erreicht werden. Die Spannung während der Pulse braucht selbstverständlich nicht konstant zu sein. Insbesondere die Spannung des positiven Spannungspulses 31 kann z.B. so variiert werden, dass Transienten minimiert werden und am Ausgang der Hochspannungsversorgung nach einer möglichst kurzen Einschwingzeit ein möglichst flaches Pulsdach erreicht wird.

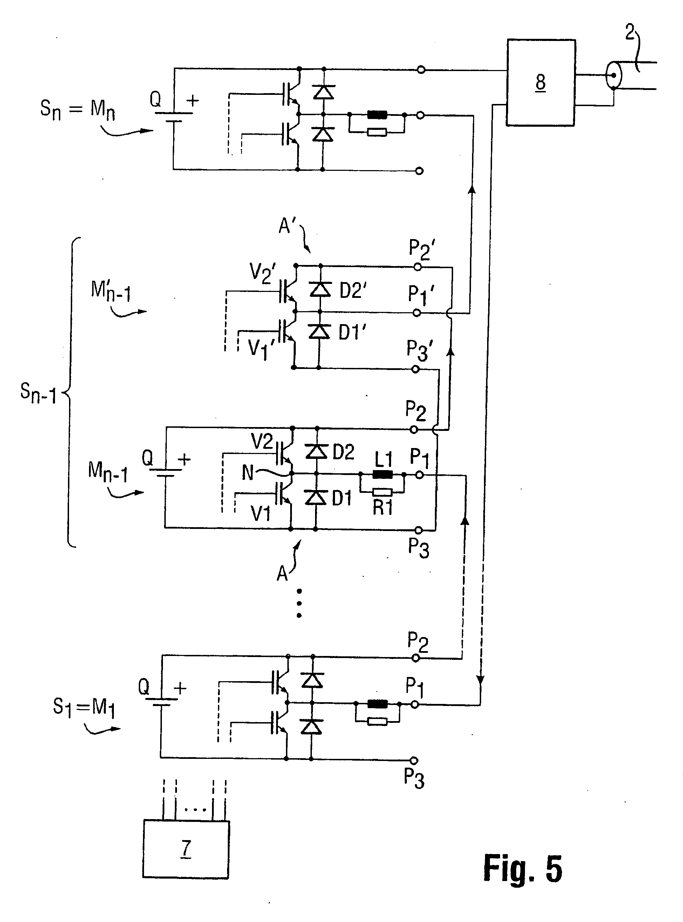

In den Figuren 5 bis 7 ist beispielhaft eine mögliche Implementierung eines geeigneten Hochspannungsmodulators illustriert. Wie insbesondere in der stark vereinfachten Darstellung der Fig. 5 illustriert ist, ist der Hochspannungsmodulator aus einer Mehrzahl von Schaltstufen $S_1$, ..., $S_{n-1}$, $S_n$ aufgebaut, die derart in Serie angeordnet sind, dass die Ausgangsspannungen der Schaltstufen am Ausgang des Hochspannungsmodulators aufsummiert werden. Jede Schaltstufe umfasst dabei ein Schaltmodul $M_1$, ..., $M_{n-1}$, $M_n$, welches an seinem Ausgangsanschlüssen selektiv entweder eine positive Ausgangsspannung erzeugt oder die Ausgangsanschlüsse leitend überbrückt, ohne aktiv eine Spannung zu erzeugen. Dabei ist ein bidirektionaler Stromfluss zwischen den Ausgangsanschlüssen möglich. Einigen der Schaltmodule ist zudem ein Inversmodul nachgeschaltet, welches es erlaubt, die Ausgangsspannung des betreffenden Schaltmoduls selektiv zu invertieren. In der Fig. 5 ist hierzu beispielhaft das Inversmodul $M'_{n-1}$ zum Schaltmodul

$M_{n-1}$ gezeigt.

Jedes der Schaltmodule umfasst eine Gleichspannungsquelle Q. Mit dieser sind zwei Halbleiter-Schaltelemente in Form von IGBTs (IGBT = Insulated-Gate Bipolar Transistor, Bipolartransistor mit isolierter Gateelektrode) V1, V2 verbunden, die in Serie geschaltet sind. Parallel zu jedem IGBT ist eine bezüglich der Gleichspannungsquelle in Sperrrichtung angeordnete Freilaufdiode D1, D2 geschaltet. Die Anordnung der IGBTs und Dioden kann als eine erste Halbbrücke A einer Brückenschaltung angesehen werden. Der gemeinsame Knoten (Mittenkontakt) N der IGBTs und der Dioden ist über eine Drossel L1 mit parallelgeschaltetem ohmschen Widerstand R1 mit einem Anschluss P1 verbunden.

Bei denjenigen Schaltstufen, bei denen dem Schaltmodul kein Inversmodul nachgeschaltet ist, bildet der Anschluss P1 den zur vorhergehenden Schaltstufe führenden ersten Ausgangsanschluss der Schaltstufe. Der zweite, zur nachfolgenden Schaltstufe führende Ausgangsanschluss ist ein Anschluss P2, an dem permanent das höhere Potential der Spannungsquelle Q anliegt. Wenn die entsprechende Schaltstufe eine positive Ausgangsspannung abgeben soll, so steuert eine Steuereinrichtung 7 die IGBTs V1, V2 dieser Schaltstufe derart, dass IGBT V1 leitend (geschlossen) und IGBT V2 nichtleitend (offen) ist. Sofern die entsprechende Schaltstufe dagegen ihre Ausgangsanschlüsse lediglich überbrücken soll, so öffnet die Steuereinheit 7 den IGBT V1 und schliesst den IGBT V2. Die Ausgangsanschlüsse P1 und P2 sind nun im Wesentlichen durch Drossel L1 und Widerstand R1 überbrückt.

Die Freilaufdioden D1, D2 schützen einerseits die IGBTs vor negativen Kollektor-Emitter-Spannungen und stellen andererseits sicher, dass ein Stromfluss durch das betreffende Modul selbst dann nicht unterbrochen wird, wenn durch eine Fehlfunktion beide IGBTs öffnen sollten. Bei positiver Stromrichtung kann ein Strom zwischen den Anschlüssen P1 und P2 jederzeit durch die Diode D2 fliessen, bei negativer Stromrichtung durch die Diode D1 und die Spannungsquelle Q.

Jedes Inversmodul umfasst eine zweite Halbbrücke A', die im Wesentlichen identisch zur ersten Halbbrücke A des zugeordneten Schaltmoduls ist und ebenfalls aus zwei in Serie angeordneten Halbleiterschaltern in Form von IGBTs V1', V2' und parallel zu jedem IGBT angeordneten Freilaufdioden D1', D2' besteht. Diese zweite Halbbrücke ist über Leitungen P2-P2' und P3-P3' mit der Spannungsquelle Q des zugeordneten Schaltmoduls verbunden. Insgesamt stehen also in der betreffenden Schaltstufe S, die aus dem Schaltmodul M und dem nachgeschalteten Inversmodul M' besteht, zwei identische, parallel angeordnete Halbbrücken zur Verfügung, die beide mit der Spannungsquelle Q verbunden sind. Die gemeinsamen Knoten der IGBTs (die Mittenkontakte) der beiden Halbbrücken sind mit den Ausgangsanschlüssen des betreffenden Schaltmoduls verbunden, wobei zwischen einem der Mittenkontakte und dem betreffenden Ausgangsanschluss wiederum eine Drossel L1 mit paralleigeschaltetem ohmschen Widerstand R1 angeordnet ist. Insgesamt steht in diesen Schaltstufen also eine vollständige H-Brücke als Vierquadrantensteller zur Verfügung. Dieser erlaubt es, eine Spannung mit positivem oder negativem Vorzeichen bei beliebiger Stromrichtung zu erzeugen. Ein Schema für eine mögliche Ansteuerung der IGBTs dieser H-Brücke ist in der folgenden Tabelle angegeben:

Tabelle 1: Mögliche Ansteuerung der Schaltelemente in einer Schaltstufe mit Inversmodul

| Spannung | V1 | V2 | V1' | V2' |
|---|---|---|---|---|
| negativ | offen | geschlossen | geschlossen | offen |
| positiv | geschlossen | offen | offen | geschlossen |

Zwischen dem derart modular aus Schaltstufen $S_1$, ..., $S_{n-1}$, $S_n$ aufgebauten Hochspannungsmodulator und der Leitung 2 bzw. dem Leitungsbündel, das den Hochspannungsmodulator mit der Primärwicklung des Pulstransformators verbindet, ist ein nur schematisch angedeutetes Ausgangsfilter 8 angeordnet. Dieses dient insbesondere zum Ausfiltern der Schaltfrequenzen des Hochspannungsmodulators. Diese Frequenzen liegen typischerweise im Bereich einiger kHz, wenn der Modulator mittels Pulsweitenmodulation (PWM) in an sich bekannter Welse betrieben wird. Insbesondere kann es sich bei dem Filter um ein Tiefpassfilter 4. Ordnung handeln, wie es in der Fig. 4 von J. Alex et al. angegeben ist. Auf die diesbezügliche Offenbarung von J. Alex et al. wird ausdrücklich verwiesen.

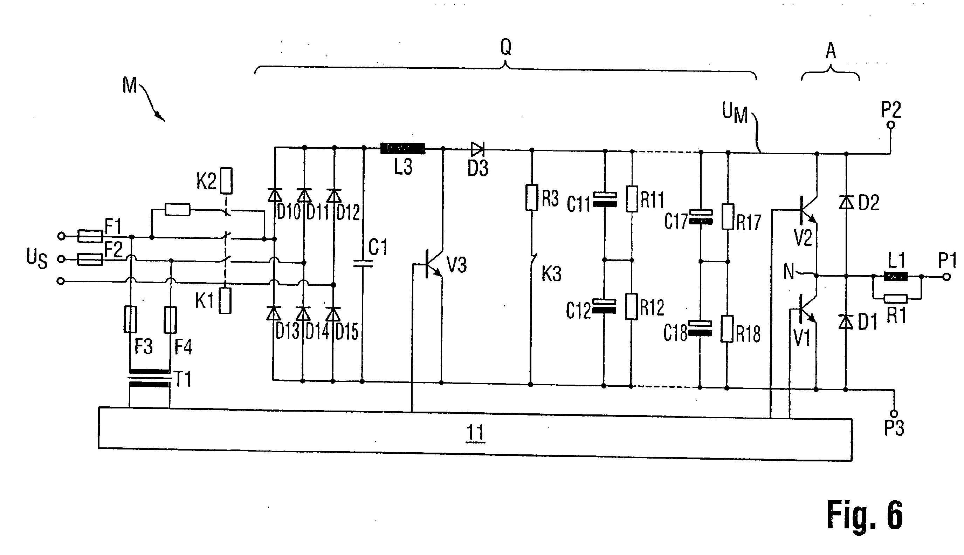

In der Fig. 6 ist beispielhaft der Aufbau eines einzelnen Schaltmoduls M dargestellt. Eine Dreiphasen-Versorgungsspannung $U_S$ eines Versorgungsnetzes wird über Sicherungen F1, F2 und Schütze K1, K2 einem Brückengleichrichter aus Dioden D10, D11, D12, D13, D14 und D15 zugeführt. Ein Aufwärtswandler (Boost Converter) mit einer Induktivität L3, einem als Halbleiterschalter wirkenden IGBT V3 und einer Freilaufdiode D3 speist eine Kondensatorbank, die aus Kondensatoren C11, C12, ..., C17, C18 aufgebaut ist, wobei jeweils zwei Kondensatoren miteinander in Serie und parallel zu einem Spannungsteiler aus Widerstandspaaren R11, R12, ..., R17, R18 geschaltet sind. Ein Schütz K3 mit Serienwiderstand R3 ermöglicht eine gezielte Entladung der Kondensatorbank.

Der Aufwärtswandler speist die Kondensatorbank und wandelt so die am Gleichrichter zur Verfügung stehende Spannung in eine Modul-Zwischenkreisspannung UM um. Während der Ausgangspulse wird Leistung vor allem aus den Kondensatoren bezogen, welche zwischen den Pulsen aus dem Versorgungsnetz wieder aufgeladen werden. Daher sinkt die Zwischenkreisspannung während der Pulse durch die Entladung der Kondensatoren etwas ab und steigt beim Aufladen wieder an. Der IGBT V3 wird insgesamt so gesteuert, dass das Versorgungsnetz mit einer möglichst konstanten Leistung belastet wird. Um die Filterung zu vereinfachen, wird der IGBT V3 vorzugsweise mit einer relativ hohen Schaltfrequenz von z.B. 20 kHz betrieben.

Die Kombination aus Gleichrichter und Aufwärtswandler stellt insgesamt eine Gleichspannungsquelle Q dar, deren Spannung UM an der schon zuvor beschriebenen Halbbrücke B anliegt.

Jedes Modul M umfasst hier eine eigene Steuereinheit 11, welche über Sicherungen F3, F4 und einen Transformator T1 mit Strom versorgt wird und einerseits den IGBT V3 des Aufwärtswandlers und andererseits die IGBTs V1, V2 der Halbbrücke B aktiv steuert. Die Steuereinheiten 11 der einzelnen Module sind mit einer zeichnerisch nicht dargestellten zentralen Steuerung verbunden, welche die Steuereinheiten 11 der Module koordiniert. Gemeinsam mit der zentralen Steuerung bilden diese Steuereinheiten die Steuereinrichtung 7, die in der Fig. 5 schematisch angedeutet ist.

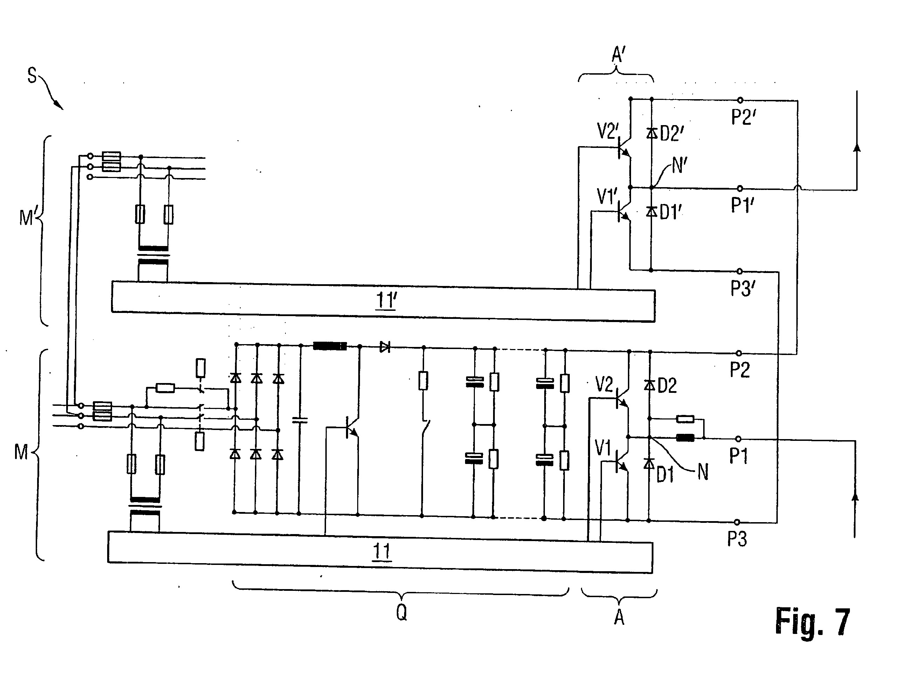

In der Fig. 7 ist eine Kombination aus einem Schaltmodul M und einem zugeordneten Inversmodul M' dargestellt. Beide Module sind grundsätzlich gleich aufgebaut, d.h. sie weisen das gleiche Schaltungslayout auf und sind auf gleich ausgebildeten Grundplatinen aufgebaut. Die Module unterscheiden sich lediglich in ihrer Bestückung, d.h. im Vorhandensein oder Weglassen bestimmter elektrischer Komponenten. So weist auch das Inversmodul M' eine Steuereinheit 11' auf. Die Spannungsquelle Q aus Gleichrichter und Aufwärtswandler entfällt. Das Modul M' besteht ansonsten im Wesentlichen lediglich aus der Halbbrücke A', welche identisch zur Halbbrücke A des Moduls M aufgebaut ist und, wie schon dargelegt, vom Modul M mit Spannung versorgt wird.

Um mit dem aus diesen Modulen aufgebauten Hochspannungsmodulator einen positiven Spannungspuls zu erzeugen, werden alle oder ein Teil der Schaltstufen so angesteuert, dass sie eine positive Ausgangsspannung abgeben, so dass sich die Ausgangsspannungen zur Pulsspannung U$_P$ addieren. Wenn umgekehrt ein negativer Spannungspuls erzeugt werden soll (insbesondere zur Vormagnetisierung und/oder Entmagnetisierung des Transformatorkerns), werden eine oder mehrere derjenigen Schaltstufen angesteuert, die ein Inversmodul aufweisen. Diese werden dann so betrieben, dass sie jeweils eine negative Ausgangsspannung abgeben, wobei sich diese Ausgangsspannungen dann zur Spannung U$_B$ oder U$_D$ addieren.

Vorteilhaft ist es, wenn nicht alle Schaltstufen zur Erzeugung der jeweils gewünschten Ausgangsspannung des Schaltverstärkers benötigt werden, sondern nur ein Teil der Schaltstufen gleichzeitig aktiv zu sein braucht. Auf diese Weise wird das System redundant und damit fehlertolerant: Falls eine Schaltstufe ausfallen sollte, kann ihre Funktion durch eine andere Schaltstufe übernommen werden. Gleichzeitig kann durch gezieltes Zu- und Wegschalten von Schaltstufen eine gleichmässige Lastverteilung über die Schaltstufen und damit eine geringere Belastung der einzelnen Schaltstufen erreicht werden.

Statt in der hier beschriebenen Weise kann der Hochspannungsmodulator auch auf eine andere Weise aufgebaut sein. So kann als Hochspannungsmodulator z.B. der Schaltverstärker der schon erwähnten WO 95/10881 eingesetzt werden. In dem dort beschriebenen Schaltverstärker weist jede Schaltstufe eine vollständige H-Brückenschaltung auf, und die Mittenkontakte dieser H-Brücken bilden die Ausgänge der jeweiligen Schaltstufe

Während bei der vorstehenden Ausführungsform jedes Schaltmodul und jedes Inversmodul seine eigene Steuereinheit 11 aufweist, kann auch eine einzige zentrale Steuereinrichtung vorgesehen sein, die die Schaltelemente direkt und zentral steuert.

Die Erfindung wird durch die nachstehenden Ansprüche definiert.

**Bezugszeichenliste**

| | |
|---|---|
| 1 | Hochspannungsmodulator/Schaltverstärker |
| 2 | Koaxialleitung |
| 3 | Widerstand |
| 4 | Kondensator |
| 5 | Pulstransformator |
| 6 | Last (Klystron) |
| 7 | Steuereinrichtung |
| 8 | Ausgangsfilter |
| 11, 11' | Steuereinheit |
| 21, 22, 23, 24 | Zweige der Hysteresekurve |
| 31 | Spannungspuls (Übertragungspuls) |
| 32 | Entmagnetisierungspuls |
| 33 | Vormagnetisierungspuls |
| 51 | Primärwicklung |

| | |
|---|---|
| 52 | Sekundärwicklung |
| 53 | Kern |
| $U_S$ | Versorgungsspannung |
| $U_A$ | Ausgangsspannung |
| $U_P$ | Pulsspannung |
| $U_B$ | Vormagnetisierungsspannung |
| $U_D$ | Entmagnetisierungsspannung |
| $I_P$ | maximaler Pulsstrom |
| $I_{P'}$ | |
| $I_B$ | Vormagnetisierungsstrom |
| $T_P$ | Pulsdauer des Übertragungspulses |
| $T_H, T_H'$ | Haltezeit |
| $T_D$ | Pulsdauer des Entmagnetisierungspulses |
| $T_0$ | Pulsabstand |
| $T_{cyc}$ | Periodendauer |
| H | magnetische Feldstärke |
| B | magnetische Flussdichte |
| $B_{sat}$ | Sättigungsflussdichte |
| $B_{rem}$ | Remanenzflussdichte |
| $\Delta B_1, \Delta B_2$ | nutzbarer Flussdichtenbereich |
| P1, P2, P3, P1', P2', P3' | Anschlüsse |
| Q | Spannungsquelle |
| $S, S_1, ..., S_{n-1}, S_n$ | Schaltstufe |
| $M, M_1, ..., M_{n-1}, M_n$ | Schaltmodul |
| $M', M'_{n-1}$ | Inversmodul |
| A, A' | Halbbrücke |
| N, N' | gemeinsamer Knoten/Mittenkontakt |
| V1, V2, V1', V2', V3 | Schaltelement (IBGT) |
| D1, D2, D1', D2', D3, D10, D11, D12, D13, D14, D15 | Diode |
| L1, L3 | Induktivität/Spule/Drossel |
| C1, C11, C12, ..., C17, C18 | Kapazität/Kondensator |
| R1, R3, R11, R12, ..., R17, R18 | ohmscher Widerstand |
| K1, K2, K3 | Schütz |
| F1, F2, F3, F4 | Sicherung |
| T1 | Transformator |

**Patentansprüche**

1. Hochspannungsversorgungsvorrichtung, aufweisend

- einen Hochspannungsmodulator (1) mit einer Mehrzahl von Schaltstufen ($S_1,...,S_n$), die jeweils eine Spannungsquelle (Q) zur Erzeugung einer Gleichspannung ($U_M$) sowie mindestens ein ansteuerbares Schaltelement (V1, V2; V1', V2') umfassen, um die Gleichspannung selektiv als Ausgangsspannung zur Verfügung zu stellen, wobei mindestens ein Teil der Schaltstufen ($S_{n-1}$) dazu ausgebildet sind, die Ausgangsspannung selektiv mit positivem oder negativem Vorzeichen zur Verfügung zu stellen, wobei die Schaltstufen ($S_1,...,S_n$) derart in Serie geschaltet sind, dass die Ausgangsspannungen der einzelnen Schaltstufen im Betrieb aufsummiert werden, und wobei die so gebildete Summenspannung ($U_A$, $U_P$, $U_D$, $U_B$) unter Bildung eines Lastkreises an einer Last anliegt,

- einen Transformator (5) mit mindestens einer Primärwicklung (51) und mindestens einer Sekundärwicklung (52), die über einen Transformatorkern (53) magnetisch mit der Primärwicklung gekoppelt ist, wobei die Primärwicklung (51) im Lastkreis des Hochspannungsmodulators (1) angeordnet ist, sowie

- eine Steuereinrichtung (7, 11, 11') für den Hochspannungsmodulator, mit welcher die Schaltelemente (V1, V2; V1', V2') zusammenwirkend verbunden sind und welche im Betrieb die Schaltelemente (V1, V2; V1', V2') derart steuert, dass der Hochspannungsmodulator an der Primärwicklung (51) mindestens einen positiven Spannungspuls ($U_P$) erzeugt,

**dadurch gekennzeichnet,**

- **dass** der Hochspannungsmodulator (1) derart ausgebildet ist, dass er einen Stromfluss durch den Lastkreis sowohl in einer positiven als auch in einer dazu entgegengesetzten negativen Richtung erlaubt, und
- **dass** die Steuereinrichtung (7, 11, 11') im Betrieb die Schaltelemente (V1, V2, V3, V4) derart steuert, dass der Hochspannungsmodulator vor dem positiven Spannungspuls (U$_P$) eine negative Vormagnetisierungsspannung (UM) abgibt, um den Transformatorkern (53) negativ vorzumagnetisieren.

2. Hochspannungsversorgungsvorrichtung nach Anspruch 1, wobei der Hochspannungsmodulator (1) modular aufgebaut ist, indem jede Schaltstufe (S$_1$,...,S$_n$) ein erstes Schaltstufenmodul (M) umfasst, welches dazu ausgebildet ist, eine unipolare Ausgangsspannung abzugeben, und indem mindestens ein Teil der Schaltstufen (S$_{n-1}$) ein zweites Schaltstufenmodul (M') umfasst, welches dazu ausgebildet ist, die Ausgangsspannung des zugeordneten ersten Schaltstufenmoduls (M) selektiv zu invertieren.

3. Hochspannungsversorgungsvorrichtung nach Anspruch 2, wobei die ersten Schaltstufenmodule (M) und die zweiten Schaltstufenmodule (M') ein identisches Schaltungslayout aufweisen und sich lediglich durch das Vorhandensein oder Weglassen vorbestimmter elektrischer Elemente unterscheiden.

4. Hochspannungsversorgungsvorrichtung nach einem der vorhergehenden Ansprüche, wobei jede Schaltstufe (S$_1$,...,S$_n$) eine erste Halbbrücke (A) aufweist, welche mit der Spannungsquelle (Q) verbunden ist und welche ein erstes und ein zweites Schaltelement (V1, V2) umfasst, wobei das erste und das zweite Schaltelement über einen gemeinsamen Knotenpunkt (N) in Serie geschaltet sind, wobei der gemeinsame Knotenpunkt (N) direkt oder indirekt mit einem ersten Ausgangsanschluss (P1) der Schaltstufe (S$_1$,...,S$_n$) verbunden ist, und wobei das erste und das zweite Schaltelement (V1, V2) derart mit der Steuereinrichtung (7, 11, 11') verbunden sind, dass sie durch die Steuereinrichtung gezielt in einen leitenden oder einen nichtleitenden Zustand bringbar sind.

5. Hochspannungsversorgungsvorrichtung nach Anspruch 4, wobei zumindest ein Teil der Schaltstufen (S$_{n-1}$) eine zweite Halbbrücke (A') aufweist, die parallel zur ersten Halbbrücke (A) mit der Spannungsquelle (Q) verbunden ist und welche ein drittes und ein viertes Schaltelement (V1', V2') umfasst, wobei das dritte und das vierte Schaltelement (V1', V2') über einen gemeinsamen zweiten Knotenpunkt (N') in Serie geschaltet sind, wobei der zweite Knotenpunkt (N') direkt oder indirekt mit einem zweiten Ausganganschluss (P1') der Schaltstufe (S$_{n-1}$) verbunden ist, und wobei das dritte und das vierte Schaltelement derart mit der Steuereinrichtung (7, 11, 11') verbunden sind, dass sie durch die Steuereinrichtung gezielt in einen leitenden oder einen nichtleitenden Zustand bringbar sind.

6. Hochspannungsversorgungsvorrichtung nach einem der vorhergehenden Ansprüche, wobei die Steuereinrichtung (11) im Betrieb die Schaltelemente (V1, V2, V1', V2') derart steuert, dass der Hochspannungsmodulator nach dem positiven Spannungspuls (U$_P$) eine negative Entmagnetisierungsspannung (U$_P$) abgibt, um den Transformatorkern (53) zumindest teilweise zu entmagnetisieren.

7. Hochspannungsversorgungsvorrichtung nach Anspruch 6, wobei die Summe der zeitlichen Integrale der Vormagnetisierungsspannung (U$_B$) und der Entmagnetisierungsspannung (U$_D$) betragsmässig im Wesentlichen dem zeitlichen Integral des Spannungspulses (U$_P$) entspricht.

8. Hochspannungsversorgungsvorrichtung nach einem der vorhergehenden Ansprüche, wobei das zeitliche Integral der Vormagnetisierungsspannung (U$_B$) betragsmässig im Wesentlichen der Hälfte des zeitlichen Integrals des Spannungspulses (U$_P$) entspricht.

9. Hochspannungsversorgungseinrichtung nach einem der vorhergehenden Ansprüche, welche ausserdem eine Sekundärlast (6) aufweist, die mit der Sekundärwicklung (52) verbunden ist und die so ausgebildet ist, dass sie einen Stromfluss im Wesentlichen lediglich während des positiven Spannungspulses (U$_P$) erlaubt.

10. Verfahren zur Erzeugung einer gepulsten Hochspannung, umfassend:

(a) Bereitstellen einer Hochspannungsversorgungsvorrichtung, welche umfasst:

• einen Hochspannungsmodulator (1) mit einer Mehrzahl von Schaltstufen (S$_1$,...,S$_n$), die dazu ausgebildet sind, im Betrieb eine Ausgangsspannung zur Verfügung zu stellen, wobei mindestens ein Teil der Schaltstufen (S$_{n-1}$) dazu ausgebildet sind, wahlweise eine positive oder eine negative Ausgangsspannung zur Verfügung zu stellen, wobei die Schaltstufen (S$_1$,...,S$_n$) derart in Serie geschaltet sind, dass die Ausgangsspannungen der einzelnen Schaltstufen im Betrieb aufsummiert werden, wobei die so gebildete Summenspannung (UM, U$_D$, U$_B$) unter Bildung eines Lastkreises an einer Last anliegt, und wobei der Hochspannungsmodulator derart ausgebildet ist, dass er einen Stromfluss im Lastkreis sowohl in einer positiven als auch in einer dazu entgegengesetzten negativen Richtung erlaubt, sowie

• einen Transformator (5) mit mindestens einer Primärwicklung (51) und mindestens einer Sekundärwicklung (52), die über einen Transformatorkern (53) magnetisch mit der Primärwicklung gekoppelt ist, wobei die Primärwicklung (51) im Lastkreis des Hochspannungsmodulators (1) angeordnet ist;

(b) Ansteuern des Hochspannungsmodulators (1) derart, dass dieser eine negative Vormagnetisierungsspannung ($U_B$) an der Primärwicklung erzeugt, um eine negative Vormagnetisierung des Transformatorkerns (53) herzustellen;

(c) Ansteuern des Hochspannungsmodulators (1) derart, dass dieser nach dem Erzeugen der Vormagnetisierungsspannung einen positiven Spannungspuls ($U_P$) an der Primärwicklung erzeugt.

**11.** Verfahren nach Anspruch 10, welches ausserdem umfasst:

(d) Ansteuern des Hochspannungsmodulators (1) derart, dass dieser an seinem Ausgang nach dem positiven Spannungspuls eine negative Entmagnetisierungsspannung ($U_D$) abgibt, um den Transformatorkern wenigstens teilweises zu entmagnetisieren.

**Claims**

1. A high-voltage supply apparatus, having

   - a high-voltage modulator (1) having a plurality of circuit stages ($S_1$, ..., Sn), which each include both a voltage source (Q) for generating a direct voltage ($U_M$) and at least one triggerable circuit element (V1, V2; V1', V2') in order to make the direct voltage selectively available as output voltage, and at least some of the circuit stages ($S_{n-1}$) are embodied for selectively making the output voltage available with a positive or negative sign, and the circuit stages ($S_1$, ..., Sn) are connected in series such that the output voltages of the individual circuit stages are added up in operation, and the thus-formed cumulative voltage ($U_A$, $U_P$, $U_D$, $U_B$) is applied to a load, forming a load circuit,
   - a transformer (5) having at least one primary winding (51) and at least one secondary winding (52), the latter being coupled magnetically to the primary winding via a transformer core (53), and the primary winding (51) being disposed in the load circuit of the high-voltage modulator (1), and
   - a controller (7, 11, 11') for the high-voltage modulator, with which controller the circuit elements (V1, V2; V1', V2') are cooperatively connected and which in operation controls the circuit elements (V1, V2; V1', V2') such that the high-voltage modulator generates at least one positive voltage pulse ($U_P$) at the primary winding (51), **characterized in that**
   - the high-voltage modulator (1) is embodied such that it permits a flow of current through the load circuit in both a positive direction and an opposite negative direction; and
   - the controller (7, 11, 11') in operation controls the circuit elements (V1, V2, V3, V4) such that the high-voltage modulator, before the positive voltage pulse ($U_P$), outputs a negative premagnetization voltage ($U_M$), in order to premagnetize the transformer core (53) negatively.

2. The high-voltage supply apparatus of claim 1, wherein the high-voltage modulator (1) is of modular construction, in that each circuit stage ($S_1$, ..., $S_n$) includes a first circuit stage module (M), which is embodied for outputting a unipolar output voltage, and at least some of the circuit stages ($S_{n-1}$) include a second circuit stage module (M'), which is embodied for selectively inverting the output voltage of the associated first circuit stage module (M).

3. The high-voltage supply apparatus of claim 2, wherein the first circuit stage module (M) and the second circuit stage module (M') have an identical circuit layout and differ from one another only in the presence or omission of predetermined electrical elements.

4. The high-voltage supply apparatus of one of the foregoing claims, wherein each circuit stage ($S_1$, ..., $S_n$) has a first half-bridge (A) which is connected to the voltage source (Q) and which includes a first and a second circuit element (V1, V2), and the first and the second circuit elements are connected in series via a common node point (N), and the common node point (N) is connected directly or indirectly to a first output terminal (P1) of the circuit stage ($S_1$, ..., $S_n$), and the first and second circuit elements (V1, V2) are connected to the controller (7, 11, 11') such that they can be put by the controller purposefully into a conductive or a nonconductive state.

**5.** The high-voltage supply apparatus of claim 4, wherein at least some of the circuit stages ($S_{n-1}$) have a second half-bridge (A'), which is connected parallel to the first half-bridge (A) to the voltage source (Q) and which includes a third and a fourth circuit element (V1', V2'), and the third and the fourth circuit elements (V1', V2') are connected in series via a common second node point (N'), and the second node point (N') is connected directly or indirectly to a second output terminal (P1') of the circuit stage ($S_{n-1}$), and the third and fourth circuit elements are connected to the controller (7, 11, 11') such that they can be put by the controller purposefully into a conductive or a nonconductive state.

**6.** The high-voltage supply apparatus of one of the foregoing claims, wherein the controller (11) in operation controls the circuit elements (V1, V2, V1', V2') such that the high-voltage modulator, after the positive voltage pulse ($U_P$), outputs a negative demagnetization voltage ($U_D$), in order to demagnetize the transformer core (53) at least partially.

**7.** The high-voltage supply apparatus of claim 6, wherein the sum of the time integrals of the premagnetization voltage ($U_B$) and of the demagnetization voltage ($U_S$) are quantitatively essentially equivalent to the time integral of the voltage pulse ($U_P$).

**8.** The high-voltage supply apparatus of one of the foregoing claims, wherein the time integral of the premagnetization voltage ($U_B$) is quantitatively essentially equivalent to half of the time integral of the voltage pulse ($U_P$).

**9.** The high-voltage supply apparatus of one of the foregoing claims, which furthermore has a secondary load (6), which is connected to the secondary winding (52) and is embodied such that it permits a flow of current essentially only during the positive voltage pulse ($U_P$).

**10.** A method for generating a pulsed high voltage, including:

(a) furnishing a high-voltage supply apparatus, which includes

• a high-voltage modulator (1) having a plurality of circuit stages ($S_1$, ..., Sn-), which are embodied in order to make an output voltage available in operation, and at least some of the circuit stages ($S_{n-1}$) are embodied for selectively making a positive or negative voltage available, and the circuit stages ($S_1$, ..., Sn) are connected in series such that the output voltages of the individual circuit stages are added up in operation, and the thus-formed cumulative voltage ($U_M$, $U_D$, $U_B$) is applied to a load, forming a load circuit, and the high-voltage modulator is embodied such that it permits a flow of current in the load circuit in both a positive direction and an opposite negative direction, and
• a transformer (5) having at least one primary winding (51) and at least one secondary winding (52), the latter being coupled magnetically to the primary winding via a transformer core (53), and the primary winding (51) being disposed in the load circuit of the high-voltage modulator (1);

(b) triggering the high-voltage modulator (1) such that it generates a negative premagnetization voltage ($U_B$) at the primary winding, in order to produce a negative premagnetization of the transformer core (53);
(c) triggering the high-voltage modulator (1) such that after the generation of the premagnetization voltage, it generates a positive voltage pulse ($U_P$) at the primary winding.

**11.** The method of claim 10, which furthermore includes:

(d) triggering the high-voltage modulator (1) such that after the positive voltage pulse, the high-voltage modulator at its output generates a negative demagnetization voltage ($U_D$), in order to demagnetize the transformer core at least partially.

**Revendications**

**1.** Dispositif d'alimentation électrique haute tension, comportant

- un modulateur de haute tension (1) comportant une pluralité d'étages de commutation ($S_1$, ..., $S_n$), ayant chacun une source de tension (Q) pour générer une tension continue ($U_M$), et au moins un élément de commutation pouvant être commandé (V1, V2, V1', V2'), pour mettre à disposition la tension continue de manière sélective en tant que tension de sortie, dans lequel au moins une partie des étages de commutation ($S_{n-1}$) est

**12**

agencée pour mettre à disposition la tension de sortie de manière sélective avec un signe positif ou négatif, dans lequel les étages de commutation ($S_1$, ..., $S_n$) sont connectés en série de telle sorte que la sommes des tensions de sortie des étages de commutation individuels va être réalisée fonctionnement, et dans lequel la tension somme ainsi obtenue ($U_A$, $U_P$, $U_D$, $U_B$) est appliquée à une charge pour produire un circuit de charge,
- un transformateur (5) ayant au moins un enroulement principal (51) et au moins un enroulement secondaire (52) qui est couplé magnétiquement à l'enroulement principal par l'intermédiaire d'un noyau de transformateur (53), dans lequel l'enroulement principal (51) est agencé dans le circuit de charge du modulateur de haute tension (1), et
- un dispositif de commande (7, 11, 11') pour le modulateur de haute tension, à l'aide duquel les éléments de commutation (V1, V2, V1', V2') sont reliés en interaction, et qui commande en fonctionnement les éléments de commutation (V1, V2, V1', V2') pour que le modulateur de haute tension génère au moins une impulsion de tension positive ($U_P$) sur l'enroulement principal (51),
**caractérisé en ce que**
- le modulateur de haute tension (1) est conçu de telle sorte qu'il permet un flux de courant à travers le circuit de charge, aussi bien dans une direction positive que dans une direction négative opposée à celle-ci, et
- le dispositif de commande (7, 11, 11') commande en fonctionnement les éléments de commutation (V1, V2, V3, V4) de telle sorte que le modulateur de haute tension émet une tension de polarisation magnétique négative ($U_M$) et ensuite l'impulsion de tension positive ($U_P$), pour polariser négativement le noyau de transformateur (53).

2. Dispositif d'alimentation électrique haute tension selon la revendication 1, dans lequel le modulateur de haute tension (1) est réalisé modulaire, dans lequel chaque étage de commutation ($S_1$, ..., $S_n$), comprend un premier module d'étages de commutation (M), qui est réalisé pour fournir une tension de sortie unipolaire, et dans lequel au moins une partie des étages de commutation ($S_{n-1}$) comprend un second module d'étages de commutation (M'), qui est réalisé pour inverser de manière sélective la tension de sortie associée au premier module d'étages de commutation (M).

3. Dispositif d'alimentation électrique haute tension selon la revendication 2, dans lequel le premier module d'étages de commutation (M) et le second module d'étages de commutation (M') présentent un agencement de circuit identique, et ne diffèrent que par la présence ou l'absence d'éléments électriques prédéterminés.

4. Dispositif d'alimentation électrique haute tension selon l'une quelconque des revendications précédentes, dans lequel chaque étage de commutation (S1, ..., Sn) comporte un premier demi-pont (A) qui est relié à la source de tension (Q), et qui comporte des premier et second éléments de commutation (V1, V2), de telle sorte que les premier et second éléments de commutation sont raccordés en série par l'intermédiaire d'un noeud commun (N), dans lequel le noeud commun (N), directement ou indirectement, est relié à une première borne de sortie (P1) de l'étage de commutation ($S_1$, ..., $S_n$), et dans lequel les premier et second éléments de commutation (V1, V2) sont reliés au dispositif de commande (7, 11, 11'), de telle sorte qu'ils sont amenés de manière ciblée, par le dispositif de commande, dans un état conducteur ou non-conducteur.

5. Dispositif d'alimentation électrique haute tension selon la revendication 4, dans lequel au moins une partie des étages de commutation ($S_{n-1}$) comprend un second demi-pont (A') qui est relié à la source de tension (Q) parallèlement au premier demi-pont (A), et comprenant des troisième et quatrième éléments de commutation (V1', V2'), de telle sorte que les troisième et quatrième élément de commutation (V1', V2') sont raccordés en série au moyen d'un second noeud commun (N'), dans lequel le second noeud (N'), directement ou indirectement, est relié à une deuxième borne de sortie (P1') de l'étage de commutation ($S_{n-1}$), et dans lequel les troisième et quatrième éléments de commutation sont reliés au dispositif de commande (7, 11, 11') de telle sorte qu'ils sont amenés de manière ciblée, par le dispositif de commande, dans un état conducteur ou non-conducteur.

6. Dispositif d'alimentation électrique haute tension selon l'une quelconque des revendications précédentes, dans lequel le dispositif de commande (11) commande les éléments de commutation (V1, V2, V1', V2') en fonctionnement de telle sorte que le modulateur de haute tension, après l'impulsion de tension positive ($U_P$), fournit une tension de dépolarisation négative ($U_D$), pour dépolariser au moins partiellement le noyau de transformateur (53).

7. Dispositif d'alimentation électrique haute tension selon la revendication 6, dans lequel la somme des intégrales temporelles de la tension de polarisation ($U_B$) et de la tension de dépolarisation (UD) correspond sensiblement en valeur à l'intégrale temporelle de l'impulsion de tension ($U_P$).

8. Dispositif d'alimentation électrique haute tension selon l'une quelconque des revendications précédentes, dans lequel l'intégrale temporelle de la tension de polarisation ($U_B$) correspond sensiblement en valeur à la moitié de l'intégrale temporelle de l'impulsion de tension ($U_P$).

9. Dispositif d'alimentation électrique haute tension selon l'une quelconque des revendications précédentes, présentant en outre un charge secondaire (6), qui est reliée à l'enroulement secondaire (52), et qui est conçue de telle sorte qu'elle permet au courant de s'écouler sensiblement uniquement pendant l'impulsion de tension positive ($U_P$).

10. Procédé de production d'une haute tension pulsée, comprenant les étapes consistant à:

    (a) la fourniture d'un dispositif d'alimentation électrique haute tension, comprenant :

        • un modulateur de haute tension (1) comportant une pluralité d'étages de commutation (S1, ..., Sn), agencés pour mettre une tension de sortie à disposition en fonctionnement, dans lequel au moins une partie des étages de commutation (Sn-1) est agencée pour mettre au choix à disposition une tension de sortie négative ou positive, dans lequel les étages de commutation (S1, ..., Sn) sont connectés en série de telle sorte que la somme des tensions de sortie des étages de commutation individuels va être réalisée en fonctionnement, dans lequel la tension somme ainsi obtenue ($U_M$, $U_D$, $U_B$) est appliquée à une charge pour produire un circuit de charge, et dans lequel le modulateur de haute tension est conçu de telle sorte qu'il permet un flux de courant à travers le circuit de charge, aussi bien dans une direction positive que dans une direction négative opposée à celle-ci, et
        • un transformateur (5) ayant au moins un enroulement principal (51) et au moins un enroulement secondaire (52) qui est couplé magnétiquement à l'enroulement principal par l'intermédiaire d'un noyau de transformateur (53), dans lequel l'enroulement principal (51) est agencé dans le circuit de charge du modulateur de haute tension (1), et

    (b) commander le modulateur de haute tension (1) de manière à ce qu'il génère une tension de polarisation négative ($U_B$) sur l'enroulement principal pour produire une polarisation négative du noyau de transformateur (53) ;
    (c) commander le modulateur de haute tension (1) de manière à ce qu'il génère, après la production de la tension de polarisation, une impulsion de tension positive ($U_P$) sur l'enroulement principal.

11. Procédé selon la revendication 10, comprenant en outre l'étape consistant à :

    (d) commander le modulateur de haute tension (1) de telle sorte que celui-ci fournit à sa sortie, après l'impulsion de tension positive, une dépolarisation négative ($U_D$) pour dépolariser au moyen partiellement le noyau de transformateur.

**Fig. 1**

Stand der Technik

**Fig. 2**

Stand der Technik

**Fig. 4**

Fig. 3

Fig. 5

Fig. 6

EP 2 099 127 B1

**Fig. 7**

EP 2 099 127 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9510881 A

**In der Beschreibung aufgeführte Nicht-Patentliteratur**

- **J. ALEX et al.** A New Klystron Modulator for XFEL Based on PSM Technology. *Proceedings of PAC07,* 2007, 2200-2202

- **J. BIELA et al.** Reset Circuits with Energy Recovery for Solid State Modulators. *Proceedings of the Pulsed Power and Plasma Science Conference,* 17. Juni 2007, 1309-1312